# EUROPEAN PATENT SPECIFICATION

(11) **EP 0 682 367 B1**
(45) Date of publication and mention of the grant of the patent: **03.09.1997**
(21) Application number: 95109303.8
(22) Date of filing: 19.06.1991
(51) Int. Cl.: H01L 23/495, H01L 23/485, H01L 21/48

(54) **Packaged semiconductor device and a manufacturing process therefore**
Verkapselte Halbleiteranordnung und ein Herstellungsverfahren dafür
Dispositif semi-conducteur encapsulé et son procédé de fabrication

(30) Priority: 25.06.1990 JP 165979/90
(43) Date of publication of application: 15.11.1995
(62) Divisional of application: 91110062.6
(73) Proprietor: FUJITSU LIMITED, Kawasaki-shi, Kanagawa 211 (JP)
(72) Inventor: Tsuji, Kazuto, Kawasaki-shi, Kanagawa, 211 (JP); Hiraoka, Tetsuya, Kawasaki-shi, Kanagawa, 213 (JP); Aoki, Tsuyoshi, Sagamihara-shi, Kanagawa, 229 (JP); Kasai, Junichi, Kawasaki-shi, Kanagawa, 213 (JP)
(74) Representative: Seeger, Wolfgang, Dipl.-Phys.

(56) References cited:
- WO-A-88/06395
- US-A- 3 959 874
- ELECTRONICS DE 1984 A 1985 : ELECTRONICS WEEK, vol. 58, no. 37, September 1985, New York US, pp. 20-21; J. LYMAN : 'Solder columns secure chip carriers to expoxy'
- PATENT ABSTRACTS OF JAPAN, vol. 12, no. 150 (E-606) 10 May 1988; & JP-A-62 266 857
- IBM TECHNICAL DISCLOSURE BULLETIN, vol. 25, no. 5, October 1982, New York US, page 2590; 'Silicon alignment frame for spherical standoff placement'

## Description

### BACKGROUND OF THE INVENTION

The present invention generally relates to packaging of semiconductor devices, and more particularly to a packaged semiconductor device that can be produced with a reduced cost.

With the progress of the fabrication process of semiconductor devices, the integration density of integrated circuits formed on a semiconductor chip is increasing ever and ever. With the increase in the integration density, the packages used for accommodating the semiconductor chip is also required to have a capability of providing a large number of interconnections leads in correspondence to the increased number of terminals on the chip.

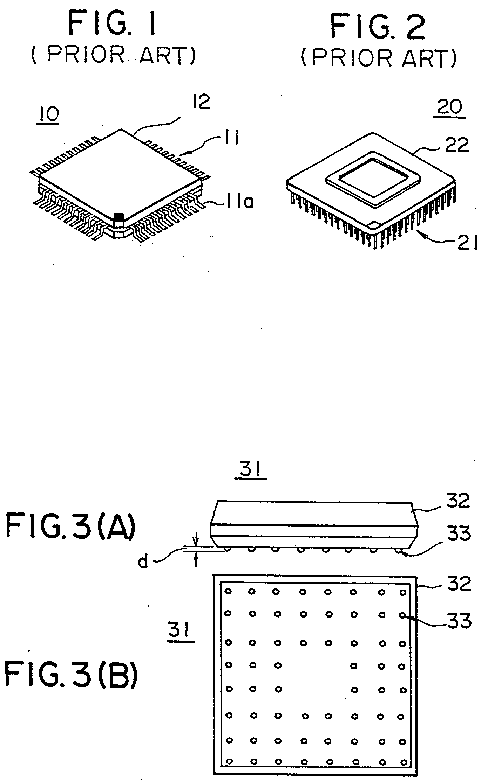

FIG.1 shows a conventional package 10 of the so-called QFP (quad flat package) type wherein a number of leads 11 are provided along the side of a package body 12. The leads 11 project laterally in the outward direction from the package body 12 and bent downward. Further, the leads 11 are bent again in the horizontal direction and form the terminals 11a that extend laterally from the body 12. Thereby, a so-called gull-wing type terminal is formed. Obviously, this type of package, having the leads along the side wall of the package body, has a problem of insufficient location for providing the interconnection leads and is not suitable for accommodating semiconductor devices having a large integration density. Further, this type of package tends to show a variation in the vertical level of the terminal part 11a of the lead 11. Generally, the level of the terminal 11a may change as much as 100 µm. However, such a large variation in the level of the terminal is not desirable from the view point of reliable interconnection.

In order to avoid the problem pertinent to the package of FIG.1, a so-called PGA (pin grid array) package is proposed as shown in FIG.2, wherein a large number of interconnection pins 21 are arranged in rows and columns on the bottom surface of a package body 22. Thereby, one can increase the number of leads on the package body 22 dramatically. For example, leads of as many as several tens in number can be provided without difficulty. This PGA package, on the other hand, has a problem in that a process for embedding the pins 21 on the package body 22 is necessary. Generally, this process includes processes of introducing a large number of minute metal rods on a package body, and apply shaking until the metal rods are settled in the holes formed in the package body as the pins 21. After the pins are settled, it is necessary to fix the pins on the package body 22. Thus, the process for fabricating the PGA package is time consuming and increases the cost of the device.

### SUMMARY OF THE INVENTION

Accordingly, it is a general object of the present invention to provide method for fabricating a novel and useful semi-conductor package wherein the foregoing problems are eliminated.

Another object of the present invention is to provide a manufacturing method for a packaged semiconductor device, wherein the cost for manufacturing the device is reduced.

Another object of the present invention is to provide a manufacturing method for a semiconductor device having a package and a thereof, wherein metal spheres are arranged in a row and column formation on a bottom surface of a package body as interconnection leads. These objects are achieved by the claimed method. Arrangement of the spheres in the row and column formation is achieved easily by using a jig that has a number of depressions arranged in correspondence to the row and column pattern of the interconnection leads. By applying a suction through the depressions, one can hold the spheres on the jig stably, and the spheres are connected mechanically as well as electrically to a lead frame either by welding or other processes such as passing through an annealing furnace. Thereby, one can easily arrange the spheres in the desired pattern such as the row and column formation, and the cost for manufacturing the device is decreased significantly. Further, by forming the depressions with a uniform diameter, one can set the amount of projection of the spheres from the bottom surface of the package body at exactly the same level. Thereby, a reliable electric interconnection to the external apparatuses can be achieved when the semiconductor device is mounted on a printed circuit board and the like.

Other object and further features of the present invention will become apparent from the following detailed description when read in conjunction with the attached drawings.

### BRIEF DESCRIPTION OF THE DRAWINGS

FIG.1 is a perspective view showing a conventional semiconductor device of the QFP type;
FIG.2 is a perspective view showing a conventional semiconductor device of the PGA type;
FIGS.3(A) and 3(B) are diagrams respectively showing the semiconductor device in the side view and bottom view;
FIGS.4(A) - 4(F) are diagrams showing the process for manufacturing the device of FIGS.3(A) and 3(B);
FIG.5 is a diagram showing the step for establishing the uniform projection of sphere-shaped leads at the bottom surface of the package body for the semiconductor device of FIGS.3(A) and 3(B);
FIGS.6(A) - 6(D) are diagrams showing the process for manufacturing the semiconductor device according to an embodiment of the present invention;
FIG.7 is a diagram showing a modification of the device;
FIGS.8(A) and 8(B) are diagrams showing other devices.

### DETAILED DESCRIPTION

FIGS.3(A) and 3(B) show a semiconductor device 31.

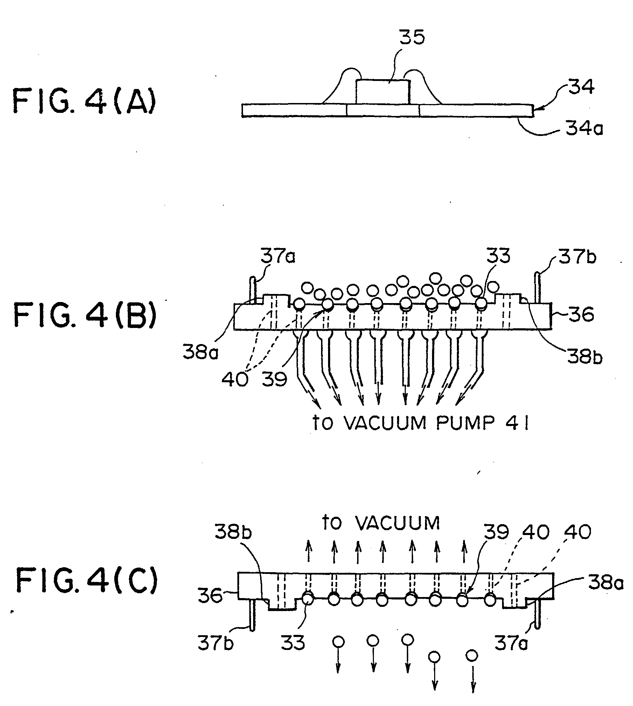

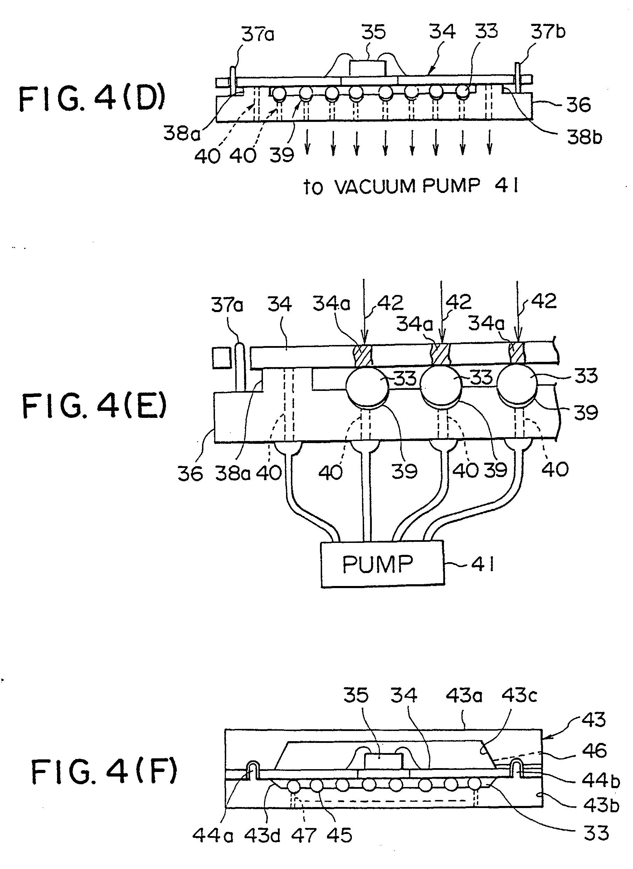

Referring to the drawings, a semiconductor chip 35 (not shown in these drawings, see FIGS.4(A) - 4(C)) is accommodated in a plastic package body 32, and a number of interconnection leads 33 are provided on the bottom surface of the package body 32 similar to the device of the PGA type. In the present embodiment, the interconnection leads are formed from a number of metal spheres arranged in the row and column formation, and projects downward from the bottom surface of the package body 32 by a distance of about 30 µm or less. As will be understood from the description below, the magnitude of projection d is extremely uniform throughout the spheres. The deviation is less than 5 µm, usually less than 1 µm.

FIGS.4(A) - 4(F) show the process for manufacturing the device of FIGS.3(A) and 3(B).

Referring to FIG.4(A), the semiconductor chip 35 mentioned previously is mounted on a lead frame 34. Further, the bonding pads formed on the semiconductor chip 35 are connected to an inner lead 34a of the lead frame 34 by a bonding wire as usual.

Next, the metal spheres 33 each having a same diameter of 1mm, for example, are supplied to a jig 36. On the upper major surface of the jig 36, a number of depressions 39 are formed in a row and column formation in correspondence to the row and column formation of the spheres 33 on the bottom surface of the package body 32 shown in FIG.3(B). In correspondence to each depression 39, a hole 10 is formed to penetrate through the body of the jig 36. Upon supplying of the spheres 33 on the jig 36, some spheres settle in the depressions 39 while other spheres cannot find the depression 39 for settling. See FIG.4(B).

In this state, a vacuum is applied at a rear surface of the jig 36 by a vacuum pump 41 (see FIG.4(E)). Thereby, the spheres 33 that are settled in the depressions 39 are held stably on the jig 36.

Next, the jig 36 is turned over as shown in FIG.4(C) and the spheres 33 that have failed settling in the depressions 39 fall off from the jig 36.

Next, the foregoing lead frame 34 is placed on the jig 36 as shown in FIG.4(D). The jig 36 is formed with a support member 38a that extends to surround the region where the depressions 33 is formed, and the lead frame 34 thus placed is held by the support member 38a. In order to establish a proper positioning in the lateral direction, guide pins 37a and 37b are formed on the jig 36, and the guide pins engage with corresponding openings formed on the lead frame 34 when the lead frame 34 is properly positioned. As will be explained in detail later, the uppermost part of the spheres 33 is aligned on a flat plane and is contacted to the flat lower major surface of the lead frame 34 with precision. It should be noted that these metal spheres can be manufactured with high precision. For example, the JIS (Japanese Industrial Standard) prescribes the allowance of diameter of metal spheres be less than 5 µm. The lead frame 34 is held stably on the jig 36 by the air pressure that is caused by the vacuum suction applied to the rear side of the jig 36. It should be noted that the penetrating hole 40 is provided also in correspondence to the support member 38a.

Next, a laser beam 12 is irradiated onto the lead frame 34 in correspondence to where the spheres 33 are located underneath. Thereby, a part 34a of the lead frame 34 is caused to melt to form a fused region 34a that fuses with the metal sphere 33 as shown in FIG.4(E). In other words, a laser welding of the spheres 33 and the lead frame 34 is established.

Next, the lead frame 34 is removed from the jig 36 together with the semiconductor chip 35 as well as the metal spheres 33 that are welded to the lead frame 34, and the lead frame 34 is placed on a second jig 43 as shown in FIG.4(F).

Referring to FIG.4(F), the jig 43 includes an upper mold 43a and a lower mold 43b, wherein the upper and lower molds are formed with spaces 43c and 43d corresponding to the resin package body 32 of the device of FIG.3(A). On the lower mold 43b, a number of depressions 45 are formed in the row and column formation in correspondence to the row and column formation of the metal spheres on the lead frame 34. Further, each depression 45 is evacuated via a hole 47 penetrating through the lower mold 43b. In order to establish a proper positioning of the mold and the lead frame, guide pins 44a and 44b are provided on the lower mold 43b, and corresponding depressions are provided in the upper mold 43a. The pins 44a and 44b may be provided to engage with the openings formed in the lead frame 34 for accommodating the guide pins 37a and 37b of the jig 36.

When the lead frame 34 is properly mounted on the jig 43 and firmly held thereto by the evacuation through the holes 47, a molten plastic is poured into the space 43c and 43d in the jig 43 via a passage 46. After curing the plastic, the jig 43 is removed and the packaged semiconductor device of FIGS.3(A) and 3(B) is obtained.

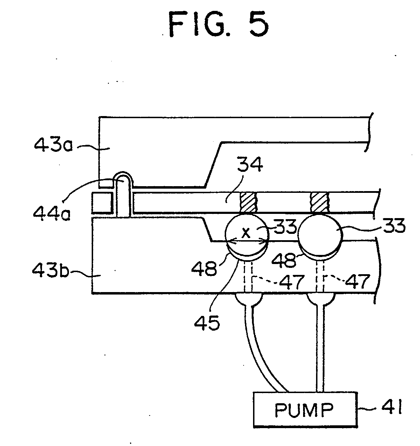

FIG.5 shows the process for achieving a uniform projection d of the spherical leads 33 in the semiconductor device 31. Referring to FIG.5, the depression 45 has a diameter x that is set smaller than the diameter of the spheres 33. Thereby, a space 48 is formed between the sphere 33 and the mold 43b, and this space 48 is evacuated via the penetrating hole 47. As the metal spheres can be manufactured to have a highly uniform diameter with the tolerance of less than 5 µm, typically less than 1 µm, one can determine the vertical positioning level of the spheres 33 on the mold 43b by setting the diameter x of the circular opening formed at the surface of the mold 43b in correspondence to the semi-spherical depression 45. Typically, the variation of the projection d can be set smaller than a few microns. The space 48 of course produces a negative pressure when evacuated via the hole 47 and the lead frame 34 is firmly held on the mold 43b.

According to the process described above, it will be understood that one can easily arrange the leads in the row and column formation in the package body without shaking and/or human intervention, and the PGA package can be manufactured with reduced cost. Generally, the diameter of the spheres is set to 0.5 - 2mm.

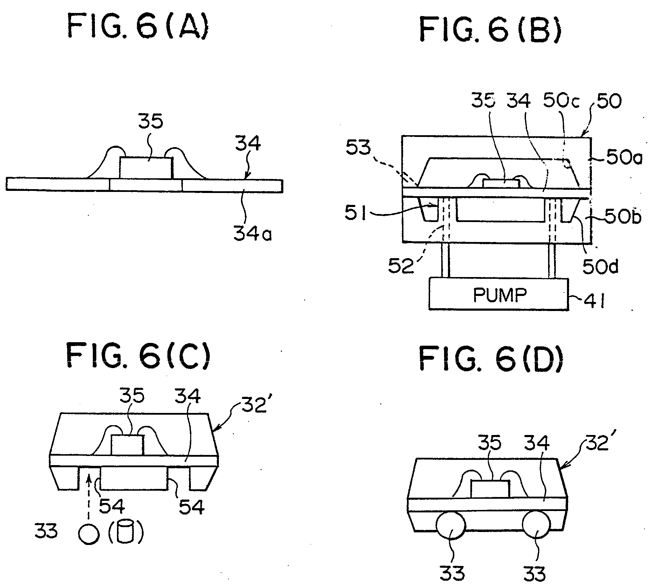

Next, an embodiment of the present invention will be described with reference to FIGS.6(A) - 6(D).

Referring to FIG.6(A), the semiconductor chip 35 is mounted on the lead frame 34 and electric connection between the chip 35 and the inner lead 34a is established similarly to the device of Fig. 3 (A), (B).

Next, the lead frame 34 is incorporated into a jig 50 that includes an upper mold 50a and a lower mold 50b. Similarly to the jig 43, the upper mold 50a is formed with a space 50c corresponding to the package body 32 of FIG.3(A). Similarly, the lower mold 50b is formed with a space 50d corresponding to the package body 32 of FIG.3(B). In the lower mold 50b, there are formed a number of projections 51 in correspondence to the space 50d, such that the projections 51 support the lead frame 34 when the lead frame 34 is mounted on the mold 50b. In each projection 51, a hole 52 is formed and the lead frame 34 is held firmly on the projections 51 when a vacuum is applied by the pump 41.

It should be noted that the projections 51 are arranged in a row and column formation in correspondence to the row and column arrangement of the spherical leads 33 on the bottom surface of the package body 32 shown in FIG.3(B). Thus, when a molten plastic is introduced into the spaces 50c and 50d inside the jig 50, the region of the lead frame 34 that is supported by the projections 51 is not covered by the plastic. Thereby, a packaged body 32' having a number of holes 54 at the bottom surface is obtained upon the curing of the plastic. See FIG.6(C). It should be noted that the holes 54 are arranged in the row and column formation, and the lead frame 34 is exposed through these holes 54.

Next, the package body 32' is turned over and the metal spheres 33 are poured on the bottom surface now facing upward. After removing the spheres 33 that have failed in settling into the holes 54, the package body 32' is passed through an annealing process. Here, a metal having a low melting point such as solder is used for the sphere 33. At least, the surface of the sphere 33 is coated by such a metal. Thereby, the spheres 33 cause melting upon annealing and establishes a mechanical as well as electric connection to the lead frame 34. See FIG.6(D).

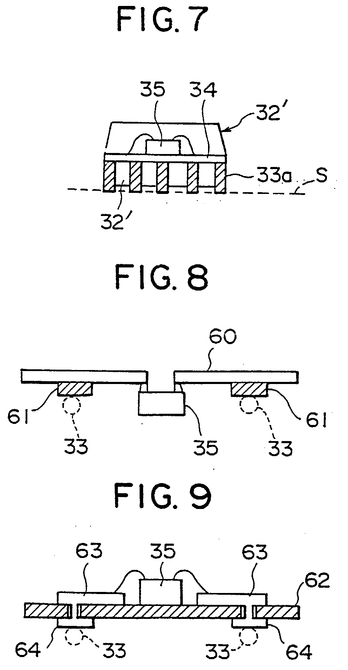

According to the present embodiment, the step for using the jig is reduced and the efficiency of production is improved further. Further, the present embodiment can be applicable to the QFP type package. In this case, the projections 51 of the jig 50 are arranged along the lateral edge of the package body 32' to be formed, in conformity with the leads that extends laterally from the package body 32'. In this case, grooves extending laterally are formed in the bottom surface of the package body 32' instead of the holes 54. By filling the grooves by rod shaped pins 33a shown in FIG.7, one can obtain a QFP type device wherein the pins extend laterally from the package body 32'. By manufacturing the QFP type device. The vertical level of the pins 33a is aligned exactly on a horizontal plane S, and the problem of the variation in the level of the leads pertinent to the conventional QFP type devices that use the gull-wing type leads, is successfully eliminated.

FIG.8 shows a device wherein the present invention is applied to the TAB (Tape Automated Bonding) process.

Referring to FIG.8, the semiconductor chip 35 is mounted on a tape carrier 60 on which a conductor pattern 61 is formed. The spherical lead 33 is connected to this conductor pattern 31 on the carrier 60. In order to hold the spherical leads 33, a jig similar to the jig 36 of Figs. 4(A) - 4(D) is used. As the process is readily derived from the previous description, further description will be omitted.

FIG.9 shows still another device, wherein the present invention is applied to the COB (Chip on Board) process.

Referring to FIG.9, the semiconductor chip 35 is mounted on a board or substrate 62 that carries conductor patterns 63 and 64 respectively on the upper and lower major surfaces of the substrate 62. The upper conductor pattern 63 is connected to the lower conductor pattern 64 via a through hole formed in the substrate 62. The spherical leads 33 are mounted on the lower conductor pattern 63 as illustrated. In this case, too, the spheres 33 are held on the depressions formed in a jig similar to the jig 36. When sealing in the package body, on the other hand, another jig similar to the jig 43 may be used.

The connection of the leads to the lead frame may be made by various welding processes other than the laser beam welding. For example, an electric welding may be used in the process of FIG.4(E).

## Claims

1. A method for fabricating a semiconductor device having a resin package, characterized by the steps of:
placing an interconnection member (34) having upper and lower major surfaces and carrying a semiconductor chip (35) on one of said upper and lower major surfaces, said interconnection member further having a conductor pattern in electrical connection to said semiconductor chip, on a jig (50b) that has a plurality of support members (51) projecting therefrom and contacting with said interconnection member when said interconnection member is placed on said jig, said plurality of support members being arranged in a predetermined pattern corresponding to said pattern of said interconnection leads;
casting a resin on said interconnection member in the state that said interconnection member is held on said jig, such said the semiconductor chip and said interconnection member are embedded in a resin package body;
removing said jig from said resin package to form a plurality of depressions (45) in said resin package in correspondence to where said support members of said jig has been contacted;
supplying a plurality of terminal members (33) having a spherical form upon said resin package body such that said terminal members settle in said plurality of depressions; and
fusing said terminal members to said interconnection member.

2. A method as claimed in claim 1 characterized in that said step of fusing comprises a step for annealing said resin package body.

3. A method as claimed in claim 1 or 2 wherein each of said terminal members (33) includes a solder alloy.

## Revendications

1. Procédé de fabrication d'un dispositif de semi-conducteur présentant un emballage en résine, caractérisé par les étapes suivantes :
- le placement d'une pièce de connexion (34) possédant des surface principales supérieur et inférieur et portant une pastille de semi-conducteur (35) sur une desdites surfaces principales supérieur et inférieur, ladite pièce de connexions possédant, de plus, un motif de conducteur raccordé, de façon électrique, auxdits composants de semi-conducteur, sur un gabarit (50b) possédant une pluralité de pièces de support (51) en projection et en contact avec ladite pièce de connexion lorsque ladite pièce de connexion est placée sur ledit gabarit, ladite pluralité de pièces de support étant agencées selon une configuration prédéterminée correspondant audit motif desdits conducteurs de connexion ;
- la coulée d'une résine sur ladite pièce de connexion dans l'état où ladite pièce de connexion est maintenue sur ledit gabarit, de telle façon que ledit composant de semi-conducteur et ladite pièce de connexion soient incorporés dans un corps d'emballage en résine ;
- l'enlèvement dudit gabarit dudit emballage en résine pour former une pluralité de creux (45) dans ledit emballage en résine selon les positions desdites pièces de support dudit gabarit en contact ;
- l'implantation d'une pluralité de pièces de borne (33) présentant une forme de sphère sur ledit corps d'emballage en résine de telle façon que lesdites pièces de borne s'établissent dans ladite pluralité de creux ; et
- la fusion desdites pièces de borne sur ladite pièce de connexion.

2. Procédé selon la revendication 1, caractérisé en ce que ladite étape de fusion comprend une étape pour le recuit dudit corps d'emballage en résine.

3. Procédé selon la revendication 1 ou 2, dans lequel chacune desdites pièces de borne (33) comprend un alliage de soudure.

## Patentansprüche

1. Verfahren zum Herstellen einer Halbleitervorrichtung mit einer Harzpackung, gekennzeichnet durch die Schritte:
Anordnen eines Zwischenverbindungsgliedes (34), das obere und unter Hauptoberflächen hat und einen Halbleiterchip (35) auf einer der oberen und unteren Hauptoberflächen trägt, welches Zwischenverbindungsglied ferner ein Leitermuster in elektrischer Verbindung mit dem Halbleiterchip hat, auf einer Vorrichtung (50b), die eine Vielzahl von Stützgliedern (51) hat, die aus ihr herausragen und mit dem Zwischenverbindungsglied in Kontakt sind, wenn das Zwischenverbindungsglied auf der Vorrichtung angeordnet ist, welche Vielzahl von Stützgliedern in einem vorbestimmten Muster angeordnet ist, das dem Muster der Zwischenverbindungsanschlüsse entspricht;
Gießen eines Harzes auf das Zwischenverbindungsglied in dem Zustand, wenn das Zwischenverbindungsglied auf der Vorrichtung gehalten wird, so daß der Halbleiterchip und das Zwischenverbindungsglied in einem Harzpackungskörper eingebettet werden;
Entfernen der Vorrichtung von der Harzpackung, um eine Vielzahl von Vertiefungen (45) in der Harzpackung in Entsprechung zu den Stellen zu bilden, wo die Stützglieder der Vorrichtung kontaktiert worden sind;
Laden einer Vielzahl von Anschlußgliedern (33), die eine kugelförmige Form haben, auf den Harzpackungskörper, so daß sich die Anschlußglieder in der Vielzahl von Vertiefungen niederlassen; und
Verschmelzen der Anschlußglieder mit dem Zwischenverbindungsglied.

2. Verfahren nach Anspruch 1, dadurch gekennzeichnet, daß der Schritt zum Verschmelzen einen Schritt zum Annealen des Harzpackungskörpers umfaßt.

3. Verfahren nach Anspruch 1 oder 2, bei dem jedes der Anschlußglieder (33) eine Lötlegierung enthält.
